## Europäisches Patentamt

## European Patent Office

## Office européen des brevets

(11) Veröffentlichungsnummer: **0 057 297**
**A2**

(12) **EUROPÄISCHE PATENTANMELDUNG**

(21) Anmeldenummer: **81201375.3**

(22) Anmeldetag: **17.12.81**

(51) Int. Cl.³: **H 01 L 25/14,** H 01 L 23/40

(30) Priorität: **02.02.81 CH 657/81**

(43) Veröffentlichungstag der Anmeldung: **11.08.82**
**Patentblatt 82/32**

(84) Benannte Vertragsstaaten: **CH DE FR LI SE**

(71) Anmelder: **BBC Aktiengesellschaft Brown, Boveri & Cie.,**
**CH-5401 Baden (CH)**

(72) Erfinder: **Schneider, Paul, Bodenächerstrasse 32,**
**CH-5417 Untersiggenthal (CH)**

(54) **Verspanneinrichtung zum Einspannen von scheibenförmigen Halbleiterelementen eines Stromrichters.**

(57) Eine Verspannvorrichtung (12) zum Einspannen von scheibenförmigen Halbleiterelementen (8) eines Stromrichters ist als eine kraftschlüssige, fest verbundene, z.B. verschweisste, aus Endplatten (1) und zugbeanspruchten Stäben (2) zusammengesetzte und tragendes Element für den Aufbau des Stromrichters bildende Einheit ausgeführt. Die Verspannvorrichtung (12) ist zweckmäßig mit Trägern (9) zur Verbindung mit weiteren Elementen (12, 10, 11) versehen und kann mehrere Stapel von Halbleiterelementen halten. Die Konstruktion besteht aus nur wenigen Teilen und ermöglicht eine beliebige elektrische Schaltung der Halbleiterelemente (8). Die Verspannvorrichtung (12) ist insbesondere für Stromrichter großer Leistung bestimmt.

6/81
PL/dh

Verspanneinrichtung zum Einspannen von scheibenförmigen
Halbleiterelementen eines Stromrichters

Die Erfindung bezieht sich auf eine Verspanneinrichtung zum
Einspannen von scheibenförmigen Halbleiterelementen eines
Stromrichters und weiteren Elementen.

Insbesondere bei Stromrichtern grosser Leistung wird in der
Regel eine grössere Anzahl von scheibenförmigen Halbleiterelementen verwendet. Je nach Leistung oder Stromrichterschaltung werden die Halbleiterelemente in Serie und/oder
parallel geschaltet. Die Halbleiterelemente müssen mittels
einer Einspannvorrichtung unter Druck gesetzt werden. Die
dazu erforderlichen Kräfte erreichen bei grössten Halbleiterelementen Werte bis zu 80 kN. Es werden verschiedene
Konstruktionen verwendet, die aus meistens zusammengeschraubten Endplatten und Zug- oder Druckbolzen bestehen,
wobei diese Bestandteile nur zur Aufnahme der Druckkraft
auf die Halbleiterelemente dienen. Zur Befestigung eines
Halbleiterstapels oder zur Herstellung eines Stromrichters
aus mehreren separat verspannten Halbleiterstapeln muss man
zusätzliche tragende Elemente verwenden, so dass die Konstruktion und die Montage kompliziert und wenig wirtschaftlich ist.

Der Erfindung liegt insbesondere die Aufgabe zu Grunde, die Nachteile des Bekannten zu beseitigen und eine Verspanneinrichtung der eingangs genannten Art zu schaffen, die mit einer verhältnismässig kleinen Anzahl von Bauelementen sowohl das Einspannen der scheibenförmigen Halbleiterelemente eines Stromrichters mit ausreichendem Druck sichert als auch die Verwendung der Verspanneinrichtung als tragendes Element für den weiteren Aufbau des Gesamtstromrichters ermöglicht.

Diese Aufgabe wird durch die in den Ansprüchen gekennzeichnete Erfindung gelöst.

Die durch die Erfindung erreichten Vorteile sind im wesentlichen darin zu sehen, dass die Konstruktion aus wenigen Teilen besteht, wobei auf wirtschaftliche Weise die Anordnung von mehreren Halbleiterelementestapeln mit beliebiger elektrischer Schaltung ermöglicht ist. Die erfindungsgemässe starre Verspanneinrichtung dient gleichzeitig als tragende Konstruktion zur Befestigung von weiteren Elementen, die für die Funktionsweise des Stromrichters benötigt werden.

Im folgenden wird die Erfindung anhand eines Ausführungsbeispiels näher erläutert.

Es zeigt

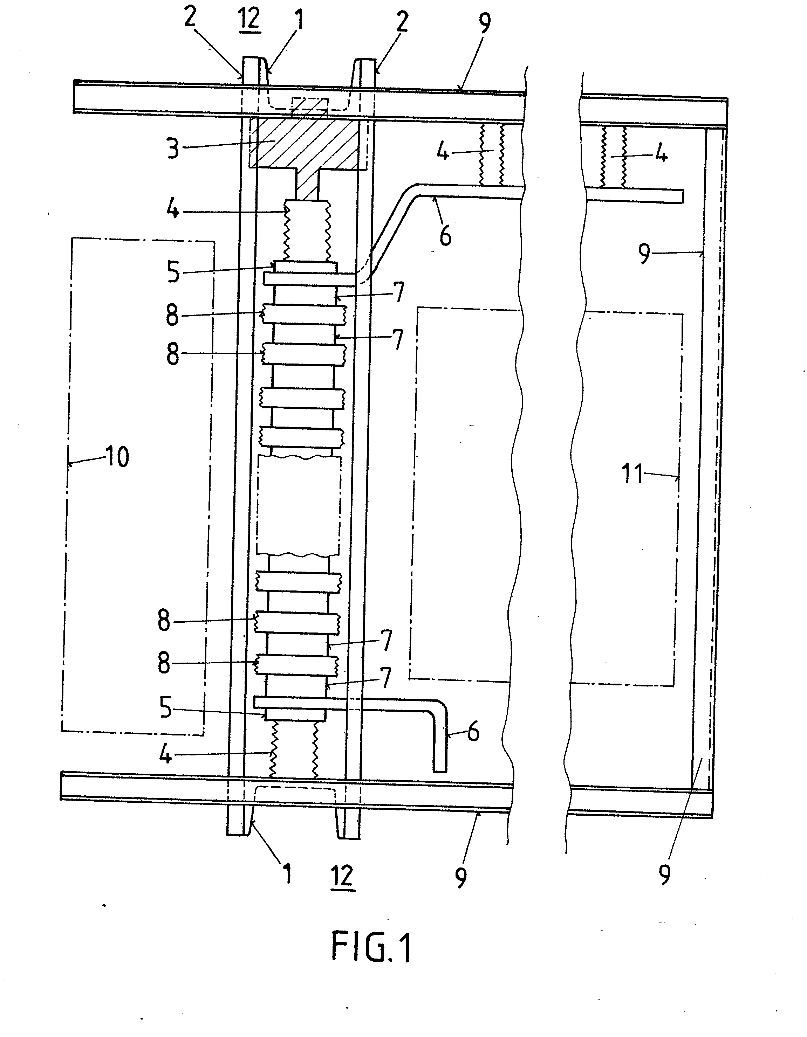

Fig. 1 eine schematische Seitenansicht auf eine beispielsweise erfindungsgemässe Verspanneinrichtung mit einigen weiteren Teilen eines Stromrichters und

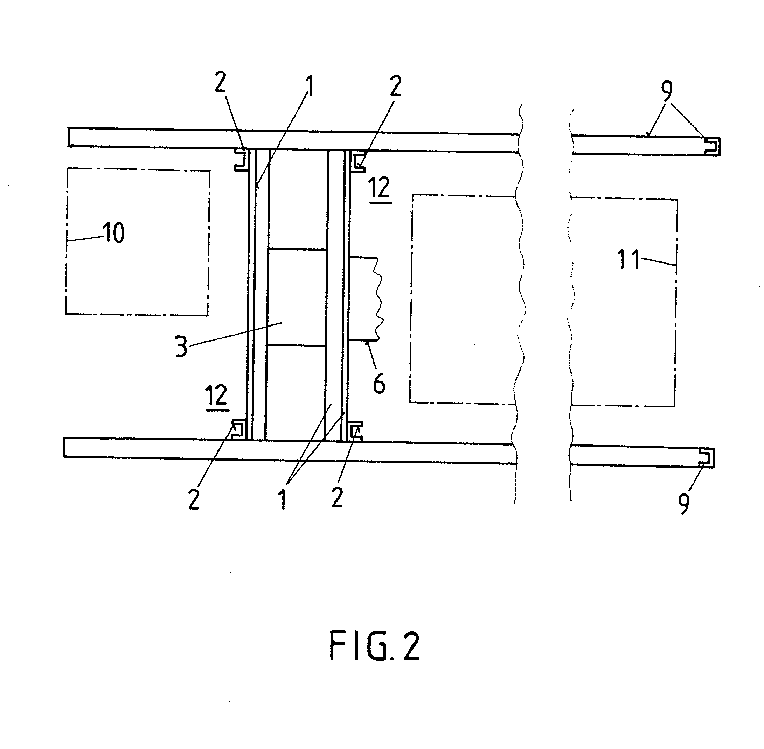

Fig. 2 einen Grundriss der Einrichtung gemäss Fig. 2.

- 3 -

Ein Stapel besteht aus scheibenförmigen Halbleiterelementen 8, Kühlern 7, die zwischen den Halbleiterelementen 8 und an beiden Enden des Stapels angeordnet sind, und aus Stromanschlüssen 6. Elektrisch isolierende Druckstützer 4 halten den Stapel zwischen zwei Endplatten 1, wobei einerseits noch ein elastischer Körper 3 zwischen dem Druckstützer 4 und der Endplatte 1 angeordnet ist. Dieser elastische Körper 3 dient zur Druckeinstellung, Druckübertragung und Aufnahme thermisch bedingter Dilatationen. Zwischen den Befestigungsstellen der Stromanschlüsse 6 und den elektrisch isolierenden Druckstützern 4 sind Scheiben 5 eingelegt. Die elektrisch isolierenden Druckstützer 4 sind auch zur Fixierung der Lage des oberen Stromanschlusses 6 verwendet. Die Stromanschlüsse 6 sind in diesem Beispiel für eine elektrische Serienschaltung dargestellt, wobei der obere Stromanschluss 6 nach hinten und der untere Stromanschluss 6 nach unten führen. Andere Schaltungen sind in an sich bekannter Weise durch Einlage von Isolationszwischenstücken und weitere Stromanschlüsse z.B. direkt an den Kühlern 7 realisierbar. Der für den Stapel der Halbleiterelemente erforderliche Druck wird durch den elastischen Körper 3, z.B. durch ein Federpaket, erhalten und ausserhalb des Stapels durch die Endplatten 1 und zugbeanspruchte Stäbe 2 kraftschlüssig übernommen. In diesem Beispiel bestehen die Endplatten 1 und die zugbeanspruchten Stäbe 2 aus Stahl, weisen U-förmige Profile auf und sind gegenseitig verschweisst. Sie können selbstverständlich aus einem anderen Material bestehen, z.B. aus Aluminium. Die eigentliche Verspannvorrichtung 12 ist also als ein Rahmen aus den Endplatten 1 und den zugbeanspruchten Stäben 2 starr ausgebildet und kann zusätzliche Tragfunktionen übernehmen, ohne die Einspannung eines Stapels oder mehrerer Stapel der Halbleiterelemente 8 zu beeinflussen. Mittels Träger 9 können zusätzlich erforderliche Bauelemente untergebracht

- 4 -

werden, wie Ansteuerungsvorrichtungen 10 der Halbleiterelemente 8 oder eine Kühlvorrichtung 11. Mehrere solche
Verspanneinrichtungen 12 können in beliebiger gegenseitiger Lage angeordnet werden, wobei eine Verspanneinrichtung mehrere Stapel halten kann. Die eventuell erforderliche elektrische Isolation kann durch zwischengeschaltete,
an sich bekannte Isolierstützer erreicht werden. Es ist
selbstverständlich, dass zwischen den Verspanneinrichtungen
12 auch weitere Baugruppen, wie z.B. Drosseln, untergebracht werden können.

B e z e i c h n u n g s l i s t e

1   Endplatten
2   zugbeanspruchte Stäbe
3   elastischer Körper
4   elektrisch isolierende Druckstützer
5   Scheiben
6   Stromanschlüsse
7   Kühler
8   scheibenförmige Halbleiterelemente
9   Träger
10  Ansteuerungsvorrichtung der Halbleiterelemente 8
11  Kühlvorrichtung
12  Verspanneinrichtung

Patentansprüche

1. Verspanneinrichtung (12) zum Einspannen von scheibenförmigen Halbleiterelementen (8) eines Stromrichters
und weiteren Elementen, z.B. Kühlern (7), elastischen
Körpern (3) und elektrisch isolierenden Druckstützern
(4), dadurch gekennzeichnet, dass die Verspanneinrichtung (12) als eine kraftschlüssige, fest verbundene,
z.B. verschweisste, aus Endplatten (1) und zugbeanspruchten Stäben (2) zusammengesetzte und tragendes
Element für den Aufbau des Stromrichters bildende Einheit ausgeführt ist.

2. Verspanneinrichtung nach Anspruch 1, dadurch gekennzeichnet, dass die Verspanneinrichtung (12) mit Trägern
(9) zur Verbindung mit weiteren Elementen, z.B. mit
weiteren Verspanneinrichtungen (12), Ansteuerungsvorrichtungen (10) der scheibenförmigen Halbleiterelemente
(8) und der Kühlvorrichtungen (11), versehen ist.

3. Verspanneinrichtung nach Anspruch 1, dadurch gekennzeichnet, dass die Endplatten (1) und die zugbeanspruchten Stäbe (2) aus Metall, z.B. aus Stahl oder Aluminium
bestehen.

4. Verspanneinrichtung nach Anspruch 1, dadurch gekennzeichnet, dass innerhalb einer Verspanneinrichtung (12)
mehrere parallel angeordnete Stapel von Halbleiterelementen (8) angeordnet sind.

5. Verspanneinrichtung nach Anspruch 1, dadurch gekennzeichnet, dass die Endplatten (1) und die zugbeanspruchten Stäbe (2) als U- und/oder L-Profile ausgebildet
sind.

0057297

FIG.1

FIG.2